(19) Europäisches Patentamt
European Patent Office
Office européen des brevets

(11) **EP 2 741 094 A1**

(12) **EUROPEAN PATENT APPLICATION**
published in accordance with Art. 153(4) EPC

(43) Date of publication:
**11.06.2014 Bulletin 2014/24**

(51) Int Cl.:
**G01R 31/02** (2006.01)   **H01L 31/04** (2014.01)
**H01L 31/042** (2014.01)

(21) Application number: **12819560.9**

(22) Date of filing: **31.07.2012**

(86) International application number:
**PCT/JP2012/069462**

(87) International publication number:
**WO 2013/018797 (07.02.2013 Gazette 2013/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.08.2011   JP 2011168705**

(71) Applicant: **JX Nippon Oil & Energy Corporation
Chiyoda-ku
Tokyo 100-8162 (JP)**

(72) Inventor: **ISHII, Takafumi
Tokyo 100-8162 (JP)**

(74) Representative: **Grünecker, Kinkeldey,
Stockmair & Schwanhäusser
Leopoldstrasse 4
80802 München (DE)**

(54) **GROUND FAULT DETECTION DEVICE, GROUND FAULT DETECTION METHOD, SOLAR ENERGY SYSTEM, AND GROUND FAULT DETECTION PROGRAM**

(57)   A first predetermined point O1 of a photovoltaic circuit 110 insulated with respect to a ground G is grounded to the ground G by a first electrical ground path 21 A, a first direct current voltage value V1 is applied to the first measurement point O1 by a first direct current power supply 23A, and a first current value I1 flowing in the first electrical ground path 21 A is measured in this state. Further, a second predetermined point 02 of the photovoltaic circuit 110 insulated with respect to the ground G is grounded to the ground G by a second electrical ground path 21B, a second direct current voltage value $V_2$ different from the first direct current voltage value $V_1$ is applied to the second predetermined point 02 by a second direct current power supply 23B, and a second current value $I_2$ flowing in the second electrical ground path 21B is measured in this state. Also, a ground fault is detected based on the first and second measured current values $I_1$ and $I_2$.

*Fig.1*

EP 2 741 094 A1

**Description**

**Technical Field**

The present invention relates to a ground fault detection device, a ground fault detection method, a photovoltaic power generation system, and a ground fault detection program.

**Background Art**

Conventionally, a system including a photovoltaic circuit which performs power generation using solar light, and a load device such as a power conditioner which consumes or converts power generated by this photovoltaic circuit is known as a general photovoltaic power generation system. In such a photovoltaic power generation system, when there is an insulation failure in the photovoltaic circuit, for example, when a person or an object touches an insulation failure point or when the insulation failure point and a metal stand or the like come in contact, a ground fault at which an electrical circuit comes in contact with the outside in an unintentional form may occur.

Therefore, for example, a ground fault detection device is disclosed as a device which detects such ground faults in Patent Literature 1. In the ground fault detection device disclosed in Patent Literature 1, a leakage current value flowing from an electrical path of a grounded photovoltaic circuit to the ground is measured, and the ground fault of the photovoltaic circuit is detected when this leakage current value exceeds a current set value, which has been set in advance.

**Citation List**

**Patent Literature**

[Patent Literature 1] Japanese Patent Laid-Open No. 2003-158282

**Summary of Invention**

**Technical Problem**

Incidentally, in recent years, for example, a device which applies an alternating current voltage to a photovoltaic circuit using an alternating current power supply, measures a current value flowing between the photovoltaic circuit and the ground through the alternating current voltage and its waveform data, and detects a ground fault based on the current value and the waveform data (a so-called ground fault detection device based on an AC biasing method) has been developed as the ground fault detection device described above. However, in this ground fault detection device, it is difficult to cancel a dielectric loss. Further, there is a problem in that expensive DPS (Digital Signal Processing) is needed and therefore a cost increases since the measurement of the waveform data is necessary.

The present invention has been made in view of such circumstances and an object of the present invention is to provide a ground fault detection device, a ground fault detection method, a photovoltaic power generation system, and a ground fault detection program capable of detecting a ground fault with high accuracy at a low cost.

**Solution to Problem**

In order to achieve the above object, a ground fault detection device according to an aspect of the present invention is a ground fault detection device for detecting a ground fault within a photovoltaic circuit in a photovoltaic power generation system including the photovoltaic circuit which performs power generation using solar light, and a load device which consumes or converts power generated by the photovoltaic circuit, the ground fault detection device including: a first electrical ground path having one side connected to a ground and the other side connectable to a first predetermined point of the photovoltaic circuit; a second electrical ground path having one side connected to the ground and the other side connectable to a second predetermined point of the photovoltaic circuit; a first direct current power supply provided on the first electrical ground path and applying a first direct current voltage value to the photovoltaic circuit; a measurement unit which measures a first measurement value for a current flowing in the first electrical ground path and a second measurement value for a current flowing in the second electrical ground path; and a control unit which performs control of operation of the measurement unit and ground fault detection based on the first and second measurement values measured by the measurement unit, wherein the control unit executes a first measurement process for causing the first electrical ground path to be connected to the photovoltaic circuit insulated with respect to the ground, causing the first direct current power supply to apply the first direct current voltage value to the photovoltaic circuit, and causing the measurement unit to measure the first measurement value in this state; a second measurement process for causing the second electrical ground path to be connected to the photovoltaic circuit insulated with respect to the ground, and causing the measurement unit to measure the second measurement value in this state; and a ground fault detection process for performing detection of the ground fault based on the first and second measured measurement values.

Further, a ground fault detection device according to an aspect of the present invention is a ground fault detection device for detecting a ground fault within a photovoltaic circuit in a photovoltaic power generation system including the photovoltaic circuit which performs power generation using solar light, and a load device which consumes or converts power generated by the photovoltaic circuit, the ground fault detection device including: a direct current voltage generation unit having one side connected to a ground and the other side connectable to a predetermined point of the photovoltaic circuit, and generating and outputting at least a first direct current voltage value and a second direct current voltage value; a measurement unit which measures a first and second measurement values for a current flowing from the predetermined point to the ground; and a control unit which performs control of operation of the measurement unit and the direct current voltage generation unit, and ground fault detection based on a measurement result of the measurement unit, wherein the control unit executes a first measurement process for causing the direct current voltage generation unit to be connected to the photovoltaic circuit insulated with respect to the ground, causing the direct current voltage generation unit to apply the first direct current voltage value to the predetermined point, and causing the measurement unit to measure the first measurement value in this state; a second measurement process for causing the direct current voltage generation unit to be connected to the photovoltaic circuit insulated with respect to the ground, causing the direct current voltage generation unit to apply the second direct current voltage value to the predetermined point, and causing the measurement unit to measure the second measurement value in this state; and a ground fault detection process for performing detection of the ground fault based on the first and second measured measurement values.

In the ground fault detection device of the one aspect, it is possible to suppress adverse effects due to a dielectric loss on the ground fault detection since apply the direct current voltage is applied to the photovoltaic circuit. Further, it is not necessary to use a DPS for ground fault detection and it is possible to easily and inexpensively perform the measurement and processing of the first and second measurement values. Further, since two measurement values, i.e., the first and second measurement values, are measured at the time of ground fault detection, the insulation resistance value and the potential can be reliably detected by setting the insulation resistance value and the potential of the ground fault point to be unknown and performing calculation based on the first and second current values. Therefore, according to one aspect described above, it is possible to detect the ground fault reliably at a low cost.

Further, the "photovoltaic circuit" may be one photovoltaic cell or one photovoltaic module, may be a photovoltaic string in which a plurality of photovoltaic modules are connected in series, or may be a photovoltaic array in which a plurality of photovoltaic strings are connected in parallel. Alternatively, this may be a system which switches a serial or parallel connection state of a plurality of photovoltaic modules at any time (hereinafter, the same applies).

Further, a ground fault detection method according to a first other aspect of the present invention is a ground fault detection method for detecting a ground fault within a photovoltaic circuit in a photovoltaic power generation system including the photovoltaic circuit which performs power generation using solar light, and a load device which consumes or converts power generated by the photovoltaic circuit, the ground fault detection method including: a first measurement step for applying a first direct current voltage value between a first predetermined point of the photovoltaic circuit insulated with respect to a ground and the ground, and measuring a first measurement value for a current flowing between the first predetermined point and the ground in this state; a second measurement step for applying a second direct current voltage value different from the first direct current voltage value between a second predetermined point of the photovoltaic circuit insulated with respect to the ground and the ground, and measuring a second measurement value for a current flowing between the second predetermined point and the ground in this state; and a ground fault detection step for detecting the ground fault based on the first and second measured measurement values.

Further, a photovoltaic power generation system according to a second other aspect of the present invention includes a photovoltaic circuit which performs power generation using solar light; a load device which consumes or converts power generated by the photovoltaic circuit; and the above ground fault detection device.

Further, a ground fault detection program according to a third other aspect of the present invention is a ground fault detection program for detecting a ground fault within a photovoltaic circuit in a photovoltaic power generation system including the photovoltaic circuit which performs power generation using solar light, and a load device which consumes or converts power generated by the photovoltaic circuit, the ground fault detection program causing a computer to execute: a first measurement function for applying a first direct current voltage value between a first predetermined point of the photovoltaic circuit insulated with respect to a ground and the ground, and measuring a first measurement value for a current flowing between the first predetermined point and the ground in this state; and a second measurement function for applying a second direct current voltage value different from the first direct current voltage value between a second predetermined point of the photovoltaic circuit insulated with respect to the ground and the ground, and measuring a second measurement value for a current flowing between the second predetermined point and the ground in this state.

The above-described action effect, in other words, an action effect of being capable of detecting a ground fault with high accuracy at a low cost, is achieved in the ground fault detection method, the photovoltaic power generation system and the ground fault detection program according to the other aspects as well.

**Advantageous Effects of Invention**

According to the present invention, it is possible to detect a ground fault with high accuracy at a low cost.

**Brief Description of Drawings**

Fig. 1 is a schematic configuration diagram illustrating a photovoltaic power generation system including a ground fault detection device according to a first embodiment.
Fig. 2 is a diagram illustrating a principle of a ground fault detection method.
Fig. 3 is another diagram illustrating the principle of the ground fault detection method.
Fig. 4 is a functional block diagram illustrating a calculation control unit of the ground fault detection device of Fig. 1.
Fig. 5 is a flowchart illustrating operation of the ground fault detection device of Fig. 1.
Fig. 6(a) is a diagram illustrating an example of a potential state of a photovoltaic circuit, and Fig. 6(b) is a diagram illustrating another example of the potential state of the photovoltaic circuit.
Fig. 7(a) is a diagram illustrating a separate example of the potential state of the photovoltaic circuit, and Fig. 7(b) is a diagram illustrating another separate example of the potential state of the photovoltaic circuit.
Fig. 8 is a schematic configuration diagram illustrating a photovoltaic power generation system including a ground fault detection device according to a second embodiment.
Fig. 9 is a schematic configuration diagram illustrating a photovoltaic power generation system including a ground fault detection device according to a third embodiment.
Fig. 10 is a schematic configuration diagram illustrating a photovoltaic power generation system including a ground fault detection device according to a fourth embodiment.
Fig. 11 is a diagram illustrating a measurement unit according to a variant.
Fig. 12 is a schematic configuration diagram illustrating a photovoltaic power generation system including a ground fault detection device according to a variant.

**Description of Embodiments**

Hereinafter, preferred embodiments of the present invention will be described in detail with reference to the drawings. Further, in the following description, the same or similar components are denoted with the same reference numerals, and a repeated description is omitted.

[First embodiment]

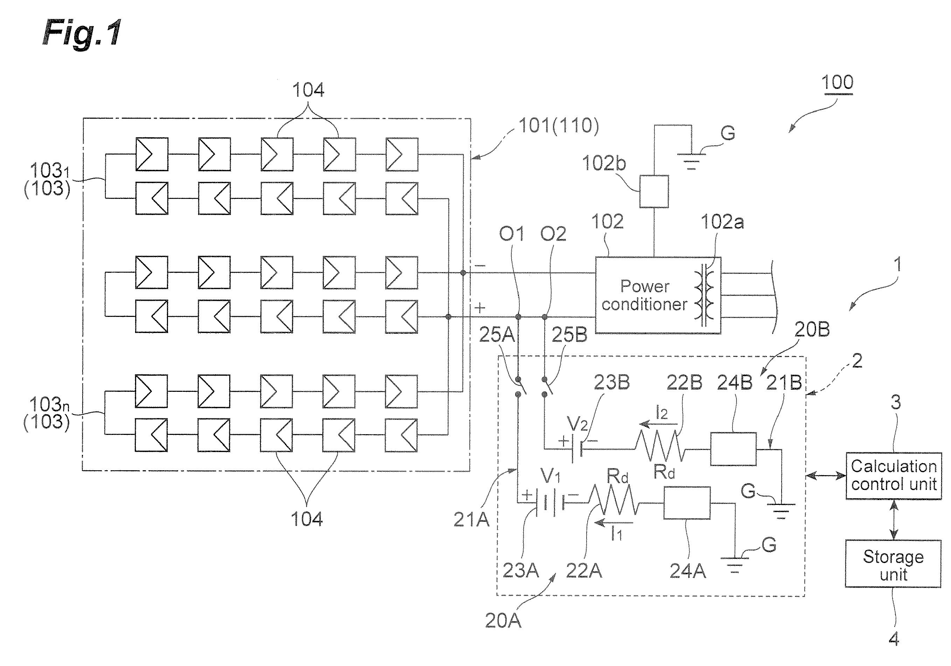

Fig. 1 is a schematic configuration diagram illustrating a photovoltaic power generation system including a ground fault detection device according to a first embodiment. A ground fault detection device 1 detects a ground fault within a photovoltaic circuit 110 in a photovoltaic power generation system 100, as illustrated in Fig. 1. Therefore, this photovoltaic power generation system 100 will first be described.

The photovoltaic power generation system 100 is a power generation system which performs power generation using solar energy, and includes a photovoltaic array 101 as the photovoltaic circuit 110, and a power conditioner (a load device) 102. The photovoltaic array 101 converts solar energy into electric energy and supplies the electric energy to the power conditioner 102 as direct current output. The photovoltaic array 101 has a configuration in which a plurality of photovoltaic strings 103 are connected in parallel. In other words, in the photovoltaic array 101, first to $n^{th}$ photovoltaic strings $103_1$ to $103_n$ are connected in parallel (n is an integer equal to or more than 2; here, n=3).

Each of a plurality of photovoltaic strings 103 has a configuration in which a plurality of (here, 10) photovoltaic modules 104 are connected in series. Positive and negative electrodes of the plurality of photovoltaic strings 103 are collected and connected in parallel to form a positive electrode bus and a negative electrode bus, and the positive electrode bus and the negative electrode bus are connected to the power conditioner 102.

The power conditioner 102 converts a direct current output supplied from the photovoltaic array 101 into an alternating current output and supplies this alternating current output to a power system (e.g., a commercial power system) of a subsequent stage. The power conditioner 102 is a transformer insulation type, and includes an isolation transformer 102a which is an insulation unit which separates and insulates the photovoltaic circuit 110 from a ground G which is a ground potential. Further, the power conditioner 102 may be a transformerless type (non-insulation). In this case, another insulation unit separate from the isolation transformer 102a is installed in the photovoltaic power generation system 100.

This power conditioner 102 has an operation voltage control function for controlling an operation voltage of the photovoltaic array 101 so that a maximum output of the photovoltaic array 101 can be obtained, and a system protection function such as safely stopping the system when abnormality of the power system is detected. Here, a surge absorber 102b for causing an overvoltage generated in the photovoltaic power generation system 100 to go to the ground G is included as a system protection function.

When a positive electrode-side setting potential and a negative electrode-side setting potential are set and the positive electrode side of the photovoltaic circuit 110 is at a potential equal to or more than the positive electrode-side setting potential, the surge absorber 102b is connected to the ground G and causes the overvoltage to go to the ground G. When the negative electrode side of the photovoltaic circuit 110 is at a potential equal to or less than the negative electrode-side setting potential, the surge absorber 102b is connected to the ground G and causes the overvoltage to go to the ground G.

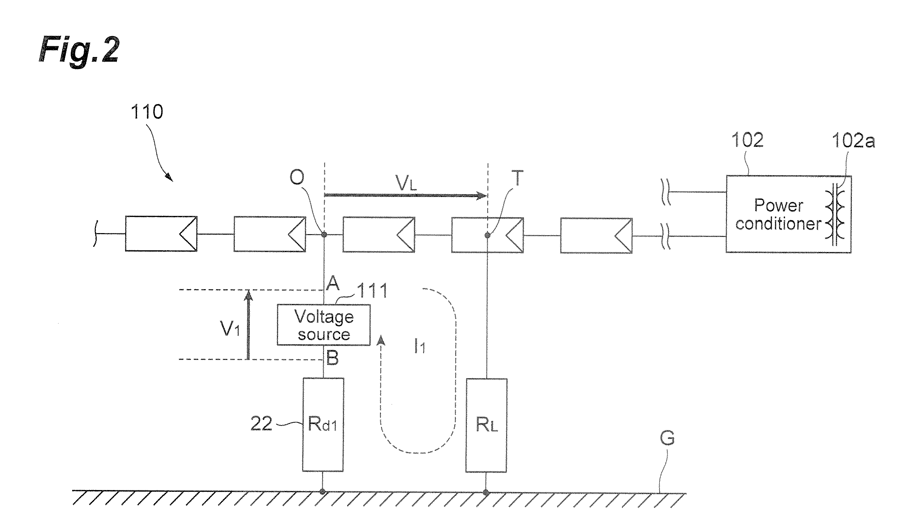

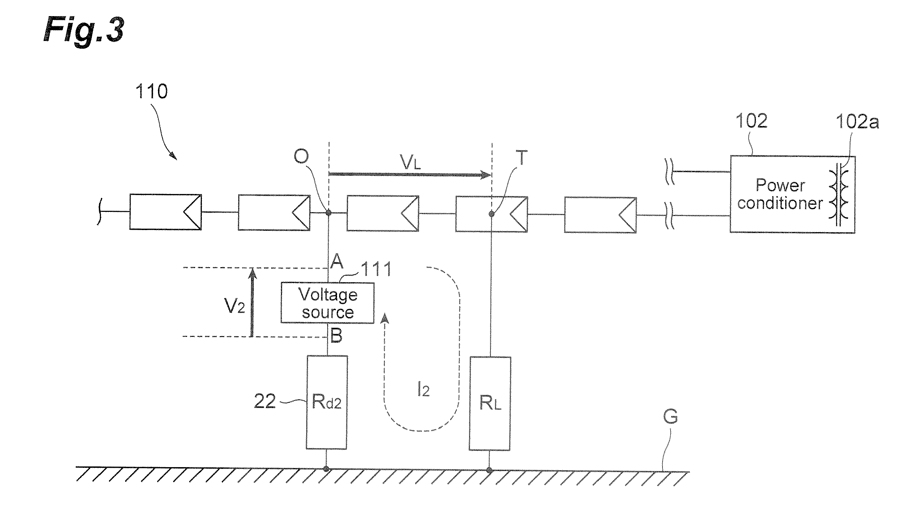

Figs. 2 and 3 are diagrams illustrating a principle of the ground fault detection method. As illustrated in Figs. 2 and 3, in the present embodiment, when a ground fault occurs, for example, at a ground fault point T in the photovoltaic circuit 110, an insulation resistance value $R_L$ and a potential $V_L$ (a ground fault position or a leakage voltage value) of the ground fault point T are detected using the following principle.

In other words, first, for example, the photovoltaic circuit 110 is insulated with respect to the ground G by the isolation transformer 102a of the power conditioner 102. A predetermined point (first and second predetermined points) O of the insulated photovoltaic circuit 110 is grounded with respect to the ground G through a voltage source (first and second DC power supplies or a DC voltage generation unit) 111. Also, a first direct current voltage value $V_1$ is applied and a first current value $I_1$ is measured. Further, a second direct current voltage value $V_2$ is applied and a second current value $I_2$ is measured.

The first and second direct current voltage values $V_1$ and $V_2$ are two types of different applied voltages. A resistor 22 is provided in the ground G side of the voltage source 111. Here, for generalization, the resistor 22 of Fig. 2 and the resistor 22 of Fig. 3 are assumed to have different resistance values $R_{d1}$ and $R_{d2}$. When a point B is set between the resistor 22 and the voltage source 111 and a point A is set between the photovoltaic circuit 110 and the voltage source 111, the first and second direct current voltage values $V_1$ and $V_2$ are potentials of the point A with respect to the point B. Further, when the voltage source 111 is provided on the ground G side of the resistor 22 (when placement of the voltage source 111 and the resistor 22 is reverse), the first and second direct current voltage values $V_1$ and $V_2$ are potentials of the point B with respect to a point between the voltage source 111 and the ground G.

The first and second current values $I_1$ and $I_2$ are currents passing through the voltage source 111, which flows from the ground G to the photovoltaic circuit 110. A potential $V_L$ of the ground fault point T is a potential of the ground fault point T with respect to the predetermined point O which is a voltage application point.

Here, Equations (2) and (3) below are established based on Kirchhoff's law. Thus, the insulation resistance value $R_L$ and the potential $V_L$ of the ground fault point T are obtained by substituting the first and second measured current values $I_1$ and $I_2$ into Equations (2) and (3) below.

$$R_L=(V_1-V_2)/(I_1-I_2)-(R_{d2}\times I_2-R_{d1}\times I_1)/(I_1-I_2) \quad \ldots \quad (2)$$

$$V_L=(V_1 \cdot I_2-V_2 \cdot I_1+I_1 \cdot I_2\times(R_{d2}-R_{d1}))/(I_1-I_2) \quad \ldots \quad (3)$$

Further, when $R_{d1}=R_{d2}=R_d$, Equation (2) above can be simplified into Equation (2)' below and Equation (3) above can be simplified into Equation (3)' below.

$$R_L=(V_1-V_2)/(I_1-I_2)-R_d \quad \ldots \quad (2)'$$

$$V_L=(V_1 \cdot I_2-V_2 \cdot I_1)/(I_1-I_2) \quad \ldots \quad (3)'$$

Referring back to Fig. 1, the ground fault detection device 1 of the present embodiment includes a measurement unit 2, a calculation control unit (a control unit or a computer) 3, and a storage unit 4. The measurement unit 2 performs measurement for ground fault detection on a disconnected photovoltaic string 103. This measurement unit 2 includes a first measurement system 20A including a first electrical ground path 21A, a first resistor 22A, a first direct current power supply 23A, and a first ammeter 24A, and a second measurement system 20B including a second electrical ground path 21B, a second resistor 22B, a second direct current power supply 23B, and a second ammeter 24B.

One side of the first electrical ground path 21A is connected to the ground G. Further, the other side of the first electrical ground path 21A is connectable to an electrical path between the positive electrode side of the photovoltaic array 101 and the power conditioner 102. Specifically, the other side of the first electrical ground path 21A is connected to a positive electrode bus of the photovoltaic array 101 through a first switch unit 25A.

The first switch unit 25A switches electrical connection/non-connection of the first electrical ground path 21 A to the photovoltaic array 101. A semiconductor switch such as an FET (Field Effect Transistor) or a mechanical switch such as a relay switch may be used as the first switch unit 25A. This first switch unit 25A is connected to the calculation control unit 5, and switches ON/OFF according to an instruction signal from the calculation control unit 5.

The first resistor 22A is provided between the first switch unit 25A and the ground G on the first electrical ground path 21A. A resistance value $R_d$ of this first resistor 22A is equal to or more than a predetermined lower limit value from the viewpoint of safety when the ground fault occurs, and equal to or less than a predetermined upper limit value from the viewpoint of ease of measuring measurement values which will be described below (the same applies to the following resistor).

The first direct current power supply 23A is provided between the first switch unit 25A and the first resistor 22A (on the photovoltaic array 101 side relative to the first resistor 22A) on the first electrical ground path 21A. In other words, one side serving as a negative electrode side of the first direct current power supply 23A is connected to the first resistor 22A, and the other side serving as its positive electrode side is connected to a first predetermined point O1 of the positive electrode side of the photovoltaic array 101 through the first switch unit 25A. This first direct current power supply 23A applies a positive direct current voltage (DC voltage) to the positive electrode side of the photovoltaic array 101. Here, the first direct current power supply 23A applies a DC voltage of the first direct current voltage value $V_1$.

The first direct current voltage value $V_1$ is equal to or more than a predetermined lower limit value from the viewpoint of improving sensitivity of the ground fault detection, and is equal to or less than a predetermined upper limit value from the viewpoint of preventing damage of a photovoltaic circuit which is a measurement target (the same applies to the following direct current voltage value). This first direct current power supply 23A is connected to the calculation control unit 5, applies the first direct current voltage value $V_1$ according to an instruction signal from the calculation control unit 5, and stores a direct current voltage value $V_1$ to be applied in the storage unit 6.

The first ammeter 24A is provided between the first resistor 22A and the ground G on the first electrical ground path 21A. This first ammeter 24A measures the first current value (a first measurement value) $I_1$ which is a leakage current value flowing through the first resistor 22A in the first electrical ground path 21 A. Further, the first ammeter 24A is connected to the calculation control unit 5, executes measurement of the first direct current voltage value $V_1$ according to an instruction signal from the calculation control unit 3, and stores a measurement result in the storage unit 4. For example, a direct current zero-phase current detector using a Hall element is used as the first ammeter 24A.

Meanwhile, one side of the second electrical ground path 21B is connected to the ground G. Further, the other side of the second electrical ground path 21 B is connectable to the electrical path between the positive electrode side of the photovoltaic array 101 and the power conditioner 102. Specifically, the other side of the second electrical ground path 21B is connected to a positive electrode bus of the photovoltaic array 101 through a second switch unit 25B.

The second switch unit 25B switches electrical connection/non-connection of the second electrical ground path 21 B to the photovoltaic array 101. A semiconductor switch such as an FET or a mechanical switch such as a relay switch may be used as the second switch unit 25B, similar to the first switch unit 25A. This second switch unit 25B is connected to the calculation control unit 5, and switches ON/OFF according to an instruction signal from the calculation control unit 5.

A second resistor 22B is provided between the second switch unit 25B and the ground G on the second electrical ground path 21B. A resistance value of this second resistor 22B is the same resistance value $R_d$ as that of the first resistor 22A.

A second direct current power supply 23B is provided between the second switch unit 25B and the first resistor 22B (on the photovoltaic array 101 side relative to the first resistor 22B) on the first electrical ground path 21B. In other words, one side serving as a negative electrode side of the second direct current power supply 23B is connected to the second resistor 22B, and the other side serving as a positive electrode side is connected to a second predetermined point 02 of the positive electrode side of the photovoltaic array 101 through the second switch unit 25B. The second direct current power supply 23B applies a positive direct current voltage (a DC voltage) to the positive electrode side of the photovoltaic array 101. Here, the second direct current power supply 23B applies a direct current voltage of the second direct current voltage value $V_2$.

The second direct current voltage value $V_2$ is a voltage value different from the first direct current voltage value $V_1$. The second direct current power supply 23B is connected to the calculation control unit 3, applies the second direct current voltage value $V_2$ according to an instruction signal from the calculation control unit 3, and stores the direct current voltage value $V_2$ to be applied in the storage unit 4.

A second ammeter 24B is provided between the second resistor 22B and the ground G on the second electrical ground path 21B. The second ammeter 24B measures the second current value (a second measurement value) $I_2$ as a leakage current value flowing through the second resistor 22B in the second electrical ground path 21B. Further, the second ammeter 24B is connected to the calculation control unit 5, executes measurement of the second direct current voltage value $V_2$ according to an instruction signal from the calculation control unit 3, and stores a measurement result in the storage unit 4. For example, a direct current zero-phase current detector using a Hall element is used as the second ammeter 24B, similar to the first ammeter 24A.

Further, in the photovoltaic circuit 110, the first predetermined point O1 as the voltage application point to which the first direct current voltage value $V_1$ is applied from the first direct current power supply 23A, and the second predetermined point 02 as the voltage application point to which the second direct current voltage value $V_2$ is applied from the second direct current power supply 23B are located on a same connection line, and have the same potentials, at least when a rated output of the photovoltaic circuit 110 is assumed. In other words, the first and second predetermined points O1 and O2 are designed to have the same potential.

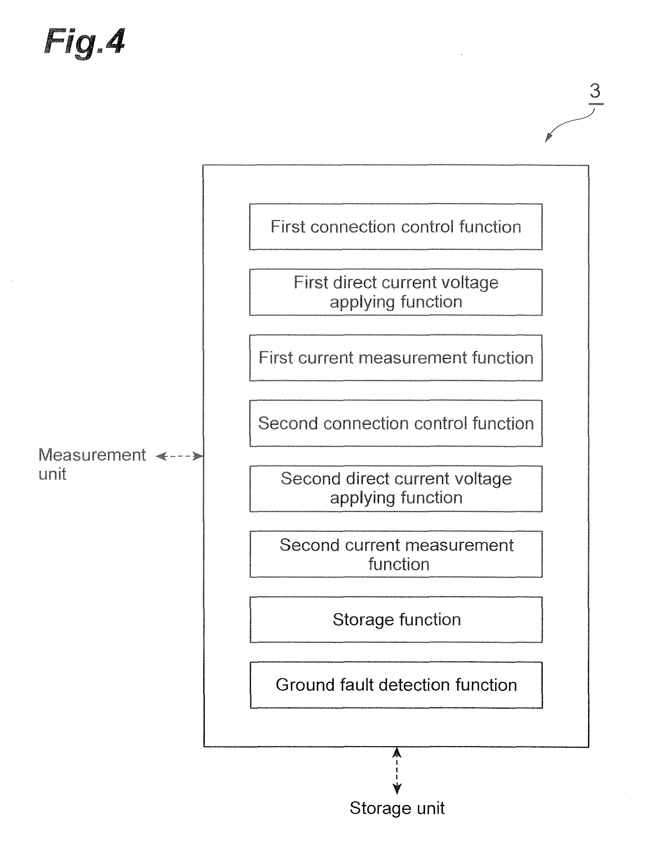

Fig. 4 is a functional block diagram illustrating the calculation control unit of the ground fault detection device of Fig. 1. The calculation control unit 3 is a unit (computer) for controlling the entire ground fault detection device 1, as illustrated in Figs. 1 and 4. The calculation control unit 3 herein executes a ground fault detection program which will be described below, and performs measurement and storage in the measurement unit 2, calculation based on a measurement result, detection of the insulation resistance value and the potential at the ground fault point T, and a determination of presence or absence of the ground fault. This calculation control unit 3 is connected to the measurement unit 2 and the storage unit 4. The calculation control unit 3 may include a CPU (Central Processing Unit) or may include an analog IC circuit or a PLD (Programmable Logic Device) circuit.

The calculation control unit 3 has, as a first measurement function, a first connection control function for controlling the first switch unit 25A to control connection of the first electrical ground path 21 A to the photovoltaic array 101, a first direct current voltage applying function for controlling the first direct current power supply 23A to apply the direct current voltage of the direct current voltage value $V_1$ to the photovoltaic array 101, and a first current measurement function for controlling the first ammeter 24A to measure the first current value $I_1$.

Further, the calculation control unit 3 has, as a second measurement function, a second connection control function for controlling the second switch unit 25B to control connection of the second electrical ground path 21B to the photovoltaic array 101, a second direct current voltage applying function for controlling the second direct current power supply 23B to apply the direct current voltage of the direct current voltage value $V_2$ to the photovoltaic array 101, and a second current measurement function for controlling the second ammeter 24B to measure the second current value $I_2$.

Further, the calculation control unit 3 has a storage function for storing a measurement situation or a measurement result and a calculation result in the storage unit 4. Further, the calculation control unit 3 has a ground fault detection function for performing calculation based on the measurement result stored in the storage unit 4, detecting the insulation resistance value $R_L$ and the potential $V_L$ of the ground fault point T, and detecting (determining) presence or absence of the ground fault.

The storage unit 4 is a recording medium for storing the ground fault detection program executed by the calculation control unit 3, a measurement result of the measurement unit 2, and a calculation result and a detection result of the calculation control unit 3, as illustrated in Fig. 1. Further, a semiconductor memory, a magnetic storage device or the like may be used as the storage unit 4. Further, when all or a part of the ground fault detection program is not stored in the storage unit 4, all or a part of the ground fault detection program may be stored in an external storage unit (e.g., a hard disk) and read to cause the calculation control unit 3 to execute a process according to ground fault detection.

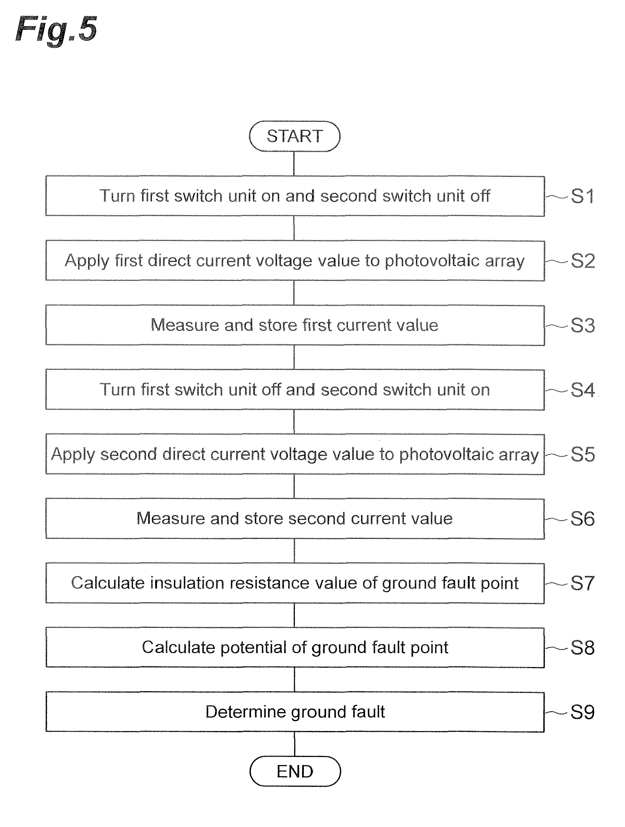

Next, an example of the ground fault detection method (operation of the ground fault detection program) performed by the ground fault detection device 1 described above will be illustrated and described with reference to a flow chart illustrated in Fig. 5.

In normal power generation of the photovoltaic power generation system 100, the first and second switch units 25A and 25B in the ground fault detection device 1 are turned off such that the electrical ground paths 21 A and 21B are not connected to the photovoltaic array 101. Also, when the ground fault in the photovoltaic array 101 is detected, various functions are executed by the calculation control unit 3 to perform the following operation.

In other words, first, the first switch unit 25A is turned on such that the first electrical ground path 21A is connected to the positive electrode side of the photovoltaic array 101, and the second switch unit 25B remains off such that the second electrical ground path 21B is not connected to the positive electrode side of the photovoltaic array 101 (S1). Also, the first direct current voltage value $V_1$ of the positive voltage is applied to the positive electrode side of the photovoltaic array 101 by the first direct current power supply 23A (S2). In this state, the first current value $I_1$ flowing in the first electrical ground path 21 A is measured by the ammeter 24A and stored in the storage unit 6 (S3).

Subsequently, the first switch unit 25A is turned off such that the first electrical ground path 21A is disconnected from the positive electrode side of the photovoltaic array 101, and the second switch unit 25B is turned on such that the second electrical ground path 21B is connected to the positive electrode side of the photovoltaic array 101 (S4). Also, the second direct current voltage value $V_2$ of a positive voltage is applied to the positive electrode side of the photovoltaic array 101 by the second direct current power supply 23B (S5). In this state, the second current value $I_2$ flowing in the first electrical ground path 21B is measured by the ammeter 24B and stored in the storage unit 6 (S6).

Subsequently, presence or absence of the ground fault is determined based on a change in the first and second current values $I_1$ and $I_2$. In other words, the insulation resistance value $R_L$ is calculated and detected from the first and second current values $I_1$ and $I_2$ using Equation (2) above (S7). Further, the potential $V_L$ of the ground fault point T is calculated and detected from the first and second current values $I_1$ and $I_2$ using Equation (3) above (S8).

Also, the calculated insulation resistance value $R_L$ and the reference resistance value stored in the storage unit 6 in advance are compared to perform a ground fault determination for the photovoltaic array 101 (S9). Specifically, when the insulation resistance value $R_L$ is smaller than the reference resistance value, "presence of ground fault" is determined, and when the insulation resistance value $R_L$ is equal to or more than the reference resistance value, "absence of ground fault" is determined.

Thus, in the present embodiment, since the direct current voltage is applied to the photovoltaic circuit 110, adverse effects due to dielectric loss on the measurement of the first and second current values $I_1$ and $I_2$ and further the detection of the ground fault can be suppressed. Further, it is not necessary to use a DPS for ground fault detection and it is possible to easily and inexpensively perform the measurement and processing of the first and second current values $I_1$ and $I_2$,

Therefore, according to the present embodiment, it is possible to detect the ground fault with high accuracy at a low cost. Further, a short-circuit operation is not necessary upon detecting the ground fault, increasing safety. Further, it is possible to suppress generation of an accident current since generation of the accident current is not assumed for the ground fault detection, for example, as in the case of ground fault detection using a zero-phase current detection method.

Particularly, in the present embodiment, the first and second direct current voltage values $V_1$ and $V_2$ are applied to the photovoltaic circuit 110, and the first and second current values $I_1$ and $I_2$ are measured upon the ground fault detection, that is, two types of direct current voltages are applied to the photovoltaic circuit 110 and two measurement values are measured. Therefore, not only the insulation resistance value $R_L$ but also the potential $V_L$ can be reliably detected irrespective of the potential $V_L$ of the ground fault point T by setting the insulation resistance value $R_L$ and the potential $V_L$ of the ground fault point T to be unknown and performing calculation based on the first and second current values $I_1$ and $I_2$, as shown in Equations (2) and (3) above. Further, when the two types of direct current voltages can be applied to the photovoltaic circuit 110 in this way, it is possible to freely control the potential relative to the ground of the photovoltaic circuit 110 and perform the ground fault detection more reliably.

Further, in the present embodiment, the first current value I1 flowing in the first resistor 22A is measured as the first measurement value in a state in which the first direct current power supply 23A applies the first direct current voltage value $V_1$ to the photovoltaic circuit 110, and the second current value $I_2$ flowing in the second resistor 22B is measured as the second measurement value in a state in which the second direct current power supply 23B applies the second direct current voltage value $V_2$ to the photovoltaic circuit 110, as described above. Thus, with the intervention of the first and second resistors 22A and 22B, damage of the photovoltaic circuit 110 due to an overcurrent can be suppressed and the first and second measurement values can be easily measured.

Further, the first and second predetermined points O1 and O2 to which the direct current voltages are applied have the same potential when rated output of the photovoltaic circuit 110 is assumed, as described above. Thus, the insulation resistance value $R_L$ and the potential $V_L$ of the ground fault point T can be calculated and detected without considering the potentials of the first and second predetermined points O1 and O2 (with the potentials of the first and second predetermined points O1 and O2 not included as parameters in Equations (2) and (3)).

Further, if a part of the photovoltaic circuit 110 is shaded, a difference may be generated between potentials of points even when the points are points designed to have the same potentials (potentials when rated output is assumed). On the other hand, in the present embodiment, since the first and second predetermined points O1 and O2 in the photovoltaic circuit 110 are located on the same connection line and therefore the first and second predetermined points O1 and O2 are maintained at substantially the same potential irrespective of an output situation of the photovoltaic circuit 110, the insulation resistance value $R_L$ and the potential $V_L$ of the ground fault point T can be accurately detected irrespective of the output situation of the photovoltaic circuit 110, as described above.

Incidentally, it is desirable for the first and second current values $I_1$ and $I_2$ to have different signs in order to perform detection of the insulation resistance value $R_L$ based on Equation (2) above with high accuracy. With the different signs, $I_1$-$I_2$ substantially becomes addition of absolute values and therefore detection sensitivity (detection precision) can prevented from being degraded due to precision loss associated with calculation (a phenomenon in which significant digits are reduced when numerical values with a rounding error are subtracted). Further, there is a problem in that the precision is easily degraded due to influence of noise when an absolute value of the difference between $I_1$ and $I_2$ is small, in addition to the precision degradation due to the precision loss associated with the calculation.

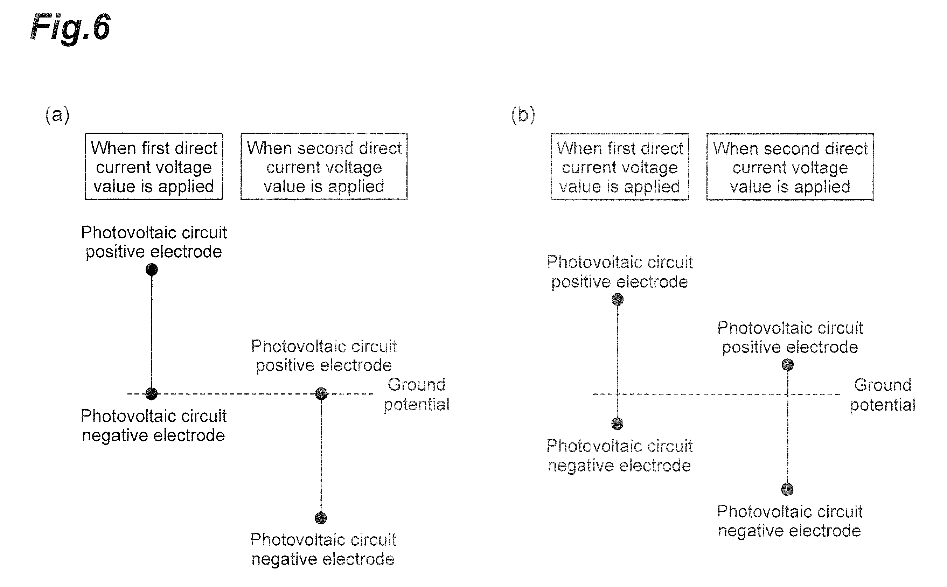

In order to realize detection sensitivity degradation due to precision loss irrespective of the ground fault point T, it is desirable for the entire photovoltaic circuit 110 to be at a potential equal to or more than the ground potential when the first direct current voltage value $V_1$ is applied and at a potential equal to or less than the ground potential when the second direct current voltage value $V_2$ is applied, as illustrated in Fig. 6(a). Thus, it is preferable to satisfy Equations (4) and (5) below.

$$V_1 = V_b + V_s/2 \qquad V_2 = V_b - V_s/2 \quad \ldots \quad (4)$$

$$|V_1 - V_2| = V_s \quad \ldots \quad (5)$$

Here,

$V_b$: a potential of predetermined points $O_1$ and $O_2$, which are voltage application points, relative to a middle point of the photovoltaic circuit 110, and
$V_s$: an inter-electrode voltage value of the photovoltaic circuit 110

On the other hand, when the difference between the first and second direct current voltage values $V_1$ and $V_2$ is very great, there is a concern of a high potential relative to the ground being generated in the photovoltaic circuit 110, and a high current flowing in the case of short-circuit or the like. In order to prevent the photovoltaic circuit 110 from being at an abnormal high potential, generally, the surge absorber 102b is often installed in the photovoltaic power generation system 100. In other words, the positive electrode of the photovoltaic circuit 110 and the negative electrode of the photovoltaic circuit 110 are often protected so that an absolute value of the potential relative to the ground does not greatly exceed the inter-electrode voltage value $V_s$ of the photovoltaic circuit 110. Specifically, by selecting the surge absorber 102b having an operation threshold value of about twice the inter-electrode voltage value $V_s$ of the photovoltaic circuit 110 and installing the surge absorber 102b between the positive electrode of the photovoltaic circuit 110 and the ground G and between the negative electrode of the photovoltaic circuit 110 and the ground G, when an absolute value of the potential relative to the ground of the positive electrode of the photovoltaic circuit 110 or an absolute value of the potential relative to the ground of the negative electrode of the photovoltaic circuit 110 exceeds about twice the inter-electrode voltage $V_s$ of the photovoltaic circuit 110, the current flows toward the ground G through the surge absorber 102b and the absolute value of the potential relative to the ground no longer increases. In this case, an upper limit of the potential relative to the ground of the positive electrode of the photovoltaic circuit 110 in which the surge absorber 102b does not work is about $2 \times V_s$, its lower limit is about $-V_s$, and it is necessary to change the photovoltaic circuit 110 in this range at the time of ground fault detection. Therefore, it is preferable for a maximum of a difference $|V_1-V_2|$ of the direct current voltage value to be applied to be equal to or lower than about $3 \times V_s$.
On the other hand, the generation of the high potential relative to the ground can be prevented by decreasing the first and second direct current voltage values $V_1$ and $V_2$ and decreasing the difference between the first and second direct current voltage values $V_1$ and $V_2$, but the detection sensitivity degradation described above becomes a problem when the difference between the first and second direct current voltage values $V_1$ and $V_2$ is very small. In this regard, it is found that the problem is not substantially generated in the detection sensitivity degradation when about half of the inter-electrode voltage value $V_s$ can be secured in the difference between the first and second direct current voltage values $V_1$ and $V_2$. Therefore, it is desirable to satisfy Equation (6) below in order to suppress the generation of the high potential relative to the ground while suppressing the concern of the detection sensitivity degradation.

$$1/2 \cdot |V_s| \leq |V_1 - V_2| \leq 3 \times |V_s| \quad \ldots \quad (6)$$

For example, when $\pm 150$ V is applied as the first and second direct current voltage values to the middle point of the photovoltaic circuit 110, the inter-electrode voltage value $V_s$ of which is 300 V, a state illustrated in Fig. 6(a) is obtained and there is no concern of the detection sensitivity degradation. Further, wen $\pm 100$ V is applied as the first and second direct current voltage values, a state illustrated in Fig. 6(b) is obtained and $V_1-V_2=200$ V. Therefore, this is not said to be much lower than $V_s$ (300 V), and concern for the detection sensitivity degradation is low. On the other hand, when $\pm 10$ V is applied as the first and second direct current voltage values, $V_1-V_2=20$ V and therefore, this is much lower than $V_s$ (300 V) and there is greater concern of detection sensitivity degradation.

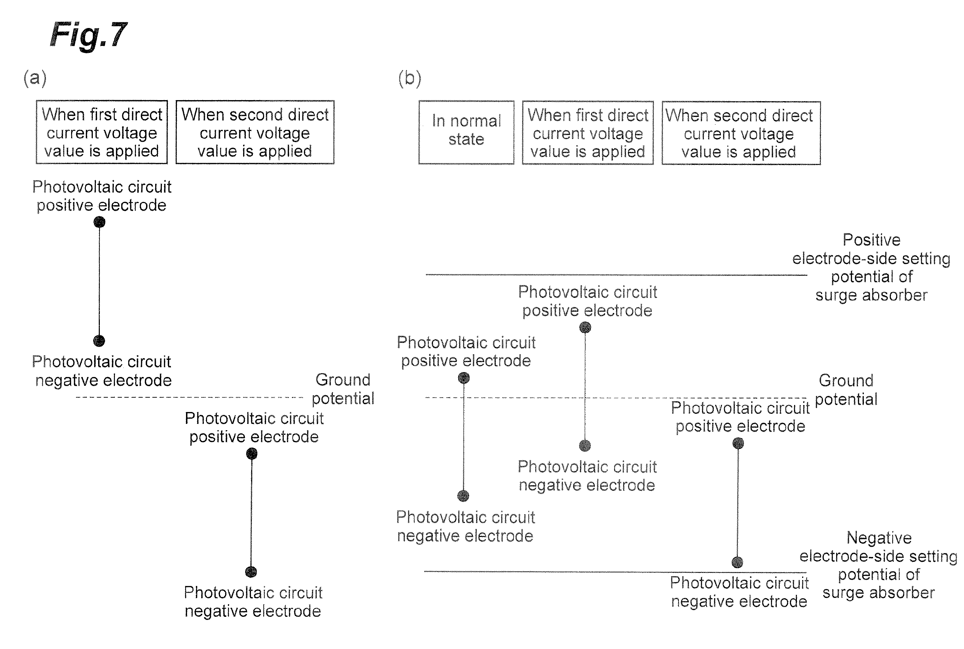

Meanwhile, for example, when there is little concern of the generation of the high potential relative to the ground, the detection sensitivity can be further increased by applying the first direct current voltage value $V_1$ so that the potential of the negative electrode of the photovoltaic circuit 110 becomes equal to or more than the ground potential and applying the second direct current voltage value $V_2$ so that the potential of the positive electrode of the photovoltaic circuit 110 becomes equal to or less than the ground potential, as illustrated in Fig. 7(a).

When the power conditioner 102 is a transformerless (non-insulation) type, it is necessary to perform, as an insulation process, at least one of disconnection between the photovoltaic circuit and the power conditioner 102, disconnection between the power conditioner 102 and a power system, and stop of the power conditioner 102. When the disconnection between the photovoltaic circuit 110 and the power conditioner 102 is performed as the insulation process, there is no concern of the operation of the surge absorber 102b obstructing the ground fault detection. However, when the disconnection between the photovoltaic circuit 110 and the power conditioner 102 is not performed, there is concern of the accurate measurement not being possible when the surge absorber 102b is operated by applying the DC voltage, as will be described below.

Further, when the power conditioner 102 is an isolation transformer type (insulation type), the photovoltaic circuit 110 is insulated and therefore no particular insulation process is necessary. However, in this case, there is concern of accurate measurement not being possible when the surge absorber 102b provided in the power conditioner 102 is operated, as follows. In other words, the surge absorber 102b is provided in the power conditioner 102 and therefore there is a concern that, if the ground fault detection is tried in a state in which the power conditioner 102 and the photovoltaic circuit 110 are connected and the surge absorber 102b is operated when the DC voltage is applied, the voltage may go to the ground G and accurate measurement may not be possible.

On the other hand, when the first direct current voltage value $V_1$ is applied so that the potential of the positive electrode of the photovoltaic circuit 110 becomes equal to or less than a positive electrode-side setting potential $V_{Lp}$ of the surge absorber 102b and the second direct current voltage value $V_2$ is applied so that the potential of the negative electrode of the photovoltaic circuit 110 becomes equal to or more than a negative electrode-side setting potential $V_{Ln}$ of the surge absorber 102b (by satisfying Equations (7) to (9) below), the first and second current values $I_1$ and $I_2$ can be measured with high accuracy without operating the surge absorber 102b.

$$V_c=(V_{Lp}+V_{Ln})/2 \quad \ldots \quad (7)$$

$$V_1=V_c+V_b+V_S/2 \quad \ldots \quad (8)$$

$$V_2=V_c+V_b-V_S/2 \quad \ldots \quad (9)$$

Further, a separate surge absorber may be provided, for example, in a connection box (not illustrated) in place of or in addition to the surge absorber 102b. When a plurality of surge absorbers are included in this way, a lowest positive electrode-side setting potential in the plurality of surge absorbers becomes a reference, and a highest negative electrode-side setting potential becomes a reference.

Thus, in the present embodiment, the device can be used with detection sensitivity improved by setting of the first and second direct current voltage values $V_1$ and $V_2$ to be applied or can be used while minimizing a burden on the photovoltaic circuit 110, and can be widely used in various uses.

[Second embodiment]

Next, a second embodiment will be described. Further, in the description of the present embodiment, differences between the second embodiment and the first embodiment will be mainly described.

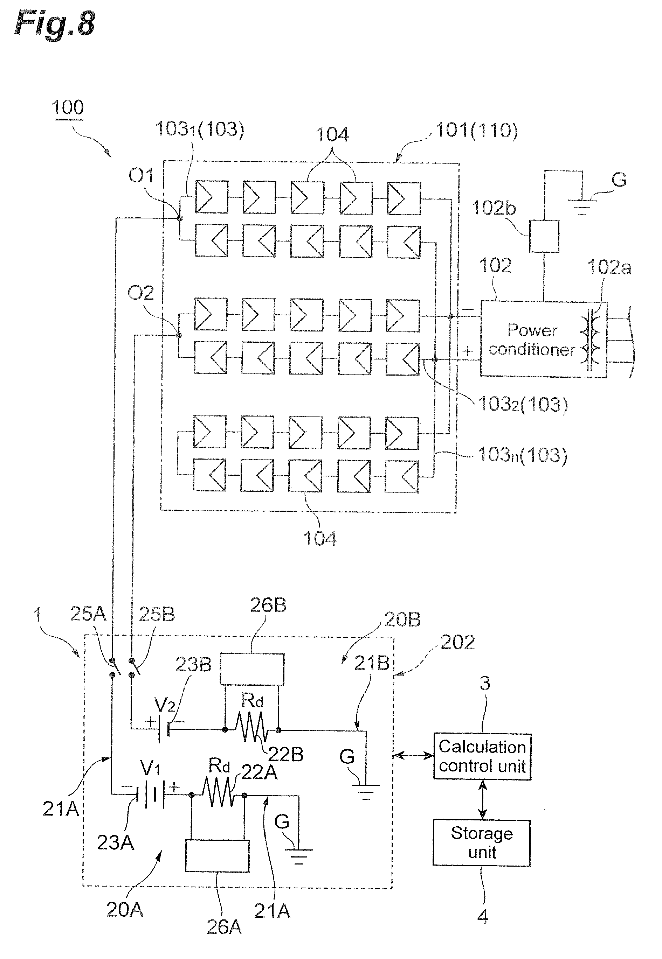

Fig. 8 is a schematic configuration diagram illustrating a photovoltaic power generation system including a ground fault detection device according to the second embodiment. A difference between the present embodiment and the first embodiment is that a measurement unit 202 is included in place of the measurement unit 2 (see Fig. 1), as illustrated in Fig. 8.

The other side of a first electrical ground path 21A of a measurement unit 202 is connected to a first predetermined point O1 which is a middle point of a photovoltaic string $103_1$. Specifically, one side serving as a negative electrode side of a first direct current power supply 23A is connected to the first predetermined point O1 which is a middle point of the photovoltaic string $103_1$ through a first switch unit 25A. Further, the other side serving as a positive electrode side of the first direct current power supply 23A is connected to a first resistor 22A.

The first electrical ground path 21A includes a first voltmeter 26A for measuring a first voltage value (a first measurement value) generated in the first resistor 22A. The first voltmeter 26A is connected between the first direct current power supply 23A and the first resistor 22A and between the first resistor 22A and the ground G The first voltmeter 21A is connected to a calculation control unit 3, and executes measurement of the first voltage value according to an instruction signal from the calculation control unit 3.

Further, the other side of a second electrical ground path 21B of the measurement unit 202 is connected to a second predetermined point 02 which is a middle point of the photovoltaic string $103_2$. Specifically, one side serving as a positive electrode side of a second direct current power supply 23B is connected to the second predetermined point 02 which is a middle point of the photovoltaic string $103_2$ through a second switch unit 25B. Further, the other side serving as a negative electrode side of the second direct current power supply 23B is connected to a second resistor 22B.

This second electrical ground path 21B includes a second voltmeter 26B for measuring a second voltage value (a second measurement value) generated in the second resistor 22B. A second voltmeter 26B is connected between the second direct current power supply 23B and the second resistor 22B and between the second resistor 22B and a ground G The second voltmeter 21B is connected to the calculation control unit 3, and executes measurement of the second voltage value according to an instruction signal from the calculation control unit 3.

Thus, the above-described action effect of detecting the ground fault with high accuracy at a low cost is achieved in the present embodiment as well. Further, in the present embodiment, even when the first and second direct current power supplies 23A and 23B apply a direct current voltage of a low voltage, states "a minimum voltage of the photovoltaic circuit 110>ground potential" and "a maximum potential of the photovoltaic circuit 110<the ground potential" can be easily generated. Further, in the present embodiment, there is an advantage that an absolute value of the voltage obtained from the first and second direct current power supplies 23A and 23B necessary to realize these states can be decreased.

[Third embodiment]

Next, a third embodiment will be described. Further, differences between the third embodiment and the second embodiment will be mainly described in the description of the present embodiment.

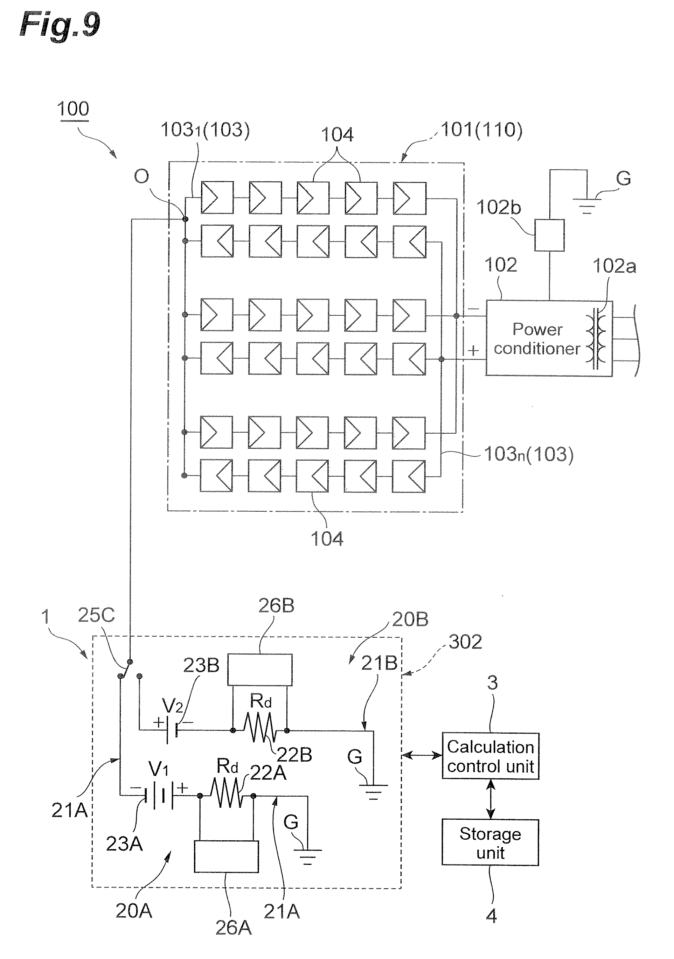

Fig. 9 is a schematic configuration diagram illustrating a photovoltaic power generation system including a ground fault detection device according to the third embodiment. The present embodiment is different from the second embodiment in that a plurality of photovoltaic strings 103 are electrically connected to one another at a middle point and a measurement unit 302 is included in place of the measurement unit 202 (see Fig. 8), as illustrated in Fig. 9.

In a measurement unit 302, the other sides of first and second electrical ground paths 21A and 21B are connected to a predetermined point O which is a middle point at which the plurality of photovoltaic strings 103 are connected to one another. Specifically, one side serving as a negative electrode side of a first direct current power supply 23A and one side serving as a positive electrode side of a second direct current power supply 23B is connected to the predetermined point O through a third switch unit 25C. The third switch unit 25C is a c contact switch, and selectively connects the predetermined point O to either the first direct current power supply 23A or the second direct current power supply 23B.

Thus, the above-described action effect of detecting the ground fault with high accuracy at a low cost is achieved in the present embodiment as well. Further, in the present embodiment, the ground fault detection of the photovoltaic circuit 110 is possible even when some of the plurality of photovoltaic strings 103 are disconnected. Further, while there is concern of being unable to apply the voltage to the middle point when some of the photovoltaic strings 103 are disconnected from the photovoltaic array 101 in the first embodiment, there is no such concern in the present embodiment and the voltage can be reliably applied to the middle point.

[Fourth embodiment]

Next, a fourth embodiment will be described. Further, differences between the fourth embodiment and the first embodiment will be mainly described in the description of the present embodiment.

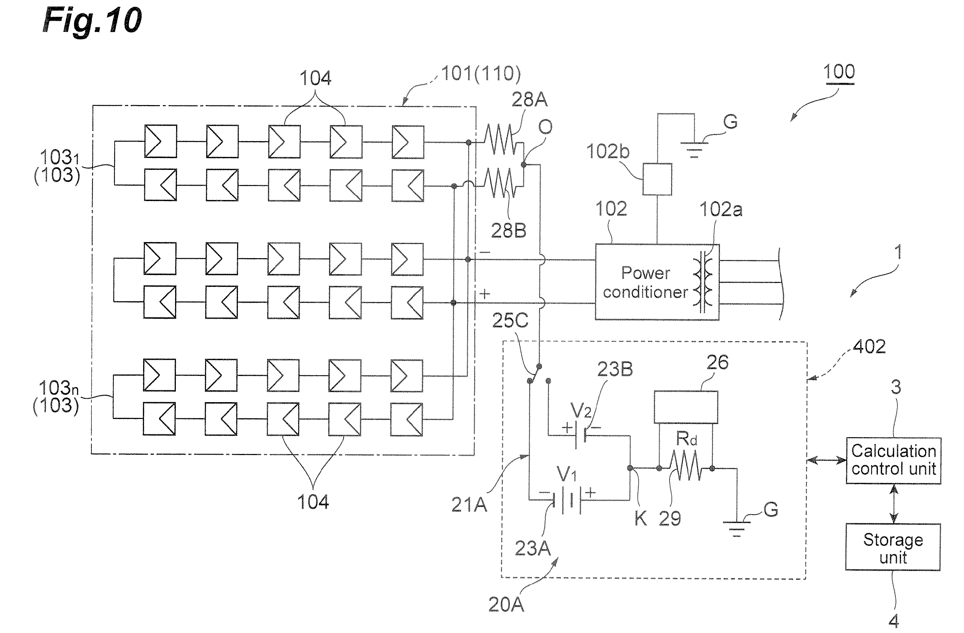

Fig. 10 is a schematic configuration diagram illustrating a photovoltaic power generation system including a ground fault detection device according to a fourth embodiment. The present embodiment is different from the first embodiment in that a measurement unit 402 is included in place of the measurement unit 2 (see Fig. 1), as illustrated in Fig. 10.

The measurement unit 402 is connected to a predetermined point O at which a positive electrode and a negative electrode of a photovoltaic array 101 are divided by two resistors 28A and 28B. The resistors 28A and 28B have the same resistance value $R_{div}$. In this measurement unit 402, one side serving as a negative electrode side of a first direct current power supply 23A and one side serving as a positive electrode side of a second direct current power supply 23B are connected to the predetermined point O through a third switch unit 25C. Meanwhile, the other side serving as a positive electrode side of the first direct current power supply 23A and the other side serving as a negative electrode side of the second direct current power supply 23B are connected to each other, and their connection point K is connected to a ground G through a resistor 29 having a resistance value $R_d$.

The third switch unit 25C is a c contact switch, and selectively connects the predetermined point O to either the first direct current power supply 23A or the second direct current power supply 23B. A voltmeter 26 is connected between the connection point K and a resistor 29 and between the resistor 29 and the ground G This voltmeter 26 is connected to a calculation control unit 3, and measures a first voltage value (a first measurement value) $V_{d1}$ or a second voltage value (a second measurement value) $V_{d2}$ generated in the resistor 29 according to an instruction signal from the calculation control unit 3.

In such an embodiment, in the calculation control unit 3, the first and second voltage flow values $V_{d1}$ and $V_{d2}$ measured by the measurement unit 402 are calculated based on Equations (10) to (13) below to obtain an insulation resistance value $R_L$ and a potential $V_L$ of a ground fault point T.

$$R_L = (V_2 - V_1)/(I_2 - I_1) - R_d - R_{div}/2 \quad \ldots \quad (10)$$

$$V_L = (I_1 \cdot V_2 - I_2 \cdot V_1)/(I_2 - I_1) \quad \ldots \quad (11)$$

$$I_1 = V_{d1}/R_d \quad \ldots \quad (12)$$

$$I_2 = V_{d2}/R_d \quad \ldots \quad (13)$$

Thus, the above-described action effect of detecting the ground fault with high accuracy at a low cost is achieved in the present embodiment as well. Further, in the present embodiment, the ground fault detection of the photovoltaic circuit 110 is possible even when some of the plurality of photovoltaic strings 103 are disconnected.

While the preferred embodiments of the present invention have been described above, the present invention is not limited to the embodiments and may be changed or applied to other things without departing from the gist defined in each claim.

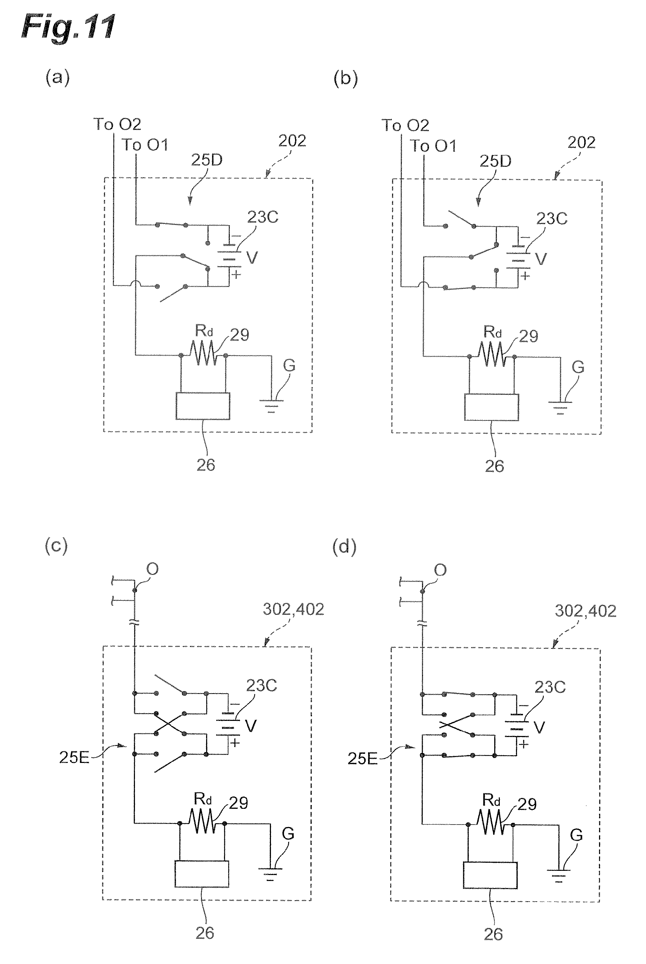

For example, the measurement unit 202 of the second embodiment may have a configuration illustrated in Fig. 11(a) or 11(b) or the measurement units 302 and 402 of the third and fourth embodiments may have a configuration illustrated in Figs. 11(c) and 11(d). Figs. 11(a) to 11(d) are diagrams illustrating states of the measurement unit according to a variant, respectively. Each of the measurement units 202, 302 and 402 according to the variant includes a direct current power supply (first or second direct current power supply or a direct current voltage generation unit) 23C which applies a direct current voltage V, a voltmeter 26, and a resistor 29. The measurement unit 202 includes a switch unit 25D, and the measurement units 302 and 402 include a switch unit 25E, as illustrated in Fig. 11.

In the measurement unit 202, the switch unit 25D connects one side serving as a negative electrode side of the direct current power supply 23C to the resistor 29 and connects the other side serving as a positive electrode side of the direct current power supply 23C to a predetermined point 02 by switching its switch element to an illustrated state, as illustrated in Fig. 11(b). Accordingly, a direct current voltage V of a positive voltage is applied to the predetermined point 02. Similarly, in the measurement units 302 and 402, the switch unit 25E connects one side as a negative electrode side of the direct current power supply 23C to the resistor 29 and connects the other side as a positive electrode side of the direct current power supply 23C to a predetermined point O by switching its switch element to an illustrated state, as illustrated in Fig. 11(c). Accordingly, a direct current voltage V of a positive voltage is applied to the predetermined point O.

Meanwhile, in the measurement unit 202, the switch unit 25D connects the one side serving as the negative electrode side of the direct current power supply 23C to a predetermined point O1 and connects the other side serving as the positive electrode side of the direct current power supply 23C to the resistor 29, by switching its switch element to an illustrated state, as illustrated in Fig. 11(a). Accordingly, the direct current voltage V of a negative voltage is applied to the predetermined point O1. Similarly, in the measurement units 302 and 402, the switch unit 25E connects the one side serving as the negative electrode side of the direct current power supply 23C to the predetermined point O and connects the other side serving as the positive electrode side of the direct current power supply 23C to the resistor 29 by switching its switch element to an illustrated state, as illustrated in Fig. 11(d). Accordingly, the direct current voltage V of the negative voltage is applied to the predetermined point O.

Thus, the first and second voltage values $V_{d1}$ and $V_{d2}$ can be measured through a connection change of one direct current power supply 23C by adopting a configuration including the switch circuit 25D (25E).

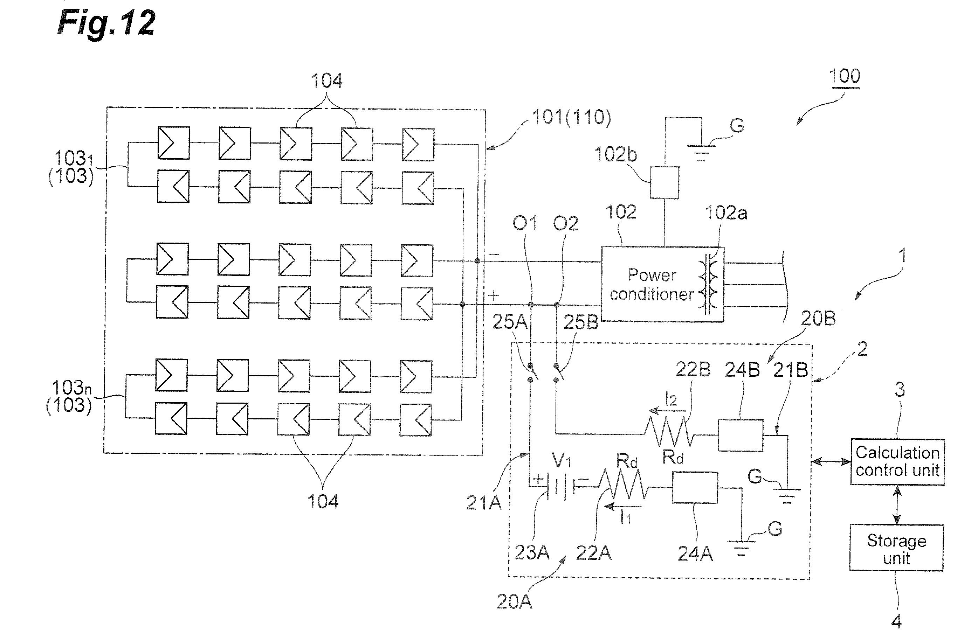

Further, in the above embodiments, while the first direct current power supply 23A provided on the first electrical ground path 21A and the second direct current power supply 23B provided on the second electrical ground path 21B are included, only one of the power supplies may be included. Specifically, a configuration in which a direct current voltage is not applied (in other words, a direct current voltage value of 0 V is applied) when the second direct current power supply 23B (see Fig. 1) is not provided on the second electrical ground path 21B and is connected to the photovoltaic array 101, for example, as illustrated in Fig. 12, may be adopted.

Further, in the embodiment described above, while the first and second electrical ground paths 21A and 21B are connectable to the positive electrode side of the photovoltaic array 101, the first and second electrical ground paths 21A and 21B may be connectable to the negative electrode side of the photovoltaic array 101. In this case, it is desirable to provide the first and second direct current power supplies 23A and 23B on the first and second electrical ground paths 21A and 21B, respectively, so that a direct current voltage of a negative voltage is applied, in order to suitably suppress generation of the high potential relative to the ground in the photovoltaic array 101.

Further, in the above embodiments, while the first electrical ground path 21A is connected to the photovoltaic array 101 to measure the first current value $I_1$ (S 1 to S3 described above) and then the second electrical ground path 21B is connected to the photovoltaic array 101 to measure the second current value $I_2$ (S4 to S6 described above), the second electrical ground path 21B may be connected to the photovoltaic array 101 to measure the second current value $I_2$ and then the first electrical ground path 21A may be connected to the photovoltaic array 101 to measure the first current value $I_1$.

Further, in the above embodiments, while the first and second current values $I_1$ and $I_2$ are directly measured as "measurement values for the current values" by the ammeters 24A and 24B, the present invention is not limited thereto and, for example, voltage values of the resistors 22A and 22B may be measured using voltmeters. In this case, the voltage values correspond to the "measurement values for the current values."

Further, in the above embodiment, an electrical ground path similar to the first and second electrical ground paths 21 A and 2 1 B may be further included. In other words, three or more types of different DC voltages may be sequentially applied to the photovoltaic array 101, a change in a leakage current value may be sensed when the DC voltages are applied, and the ground fault may be detected.

Further, the predetermined points O1 and O2 are not limited to those on the same connection line or the same potential and may be any points electrically connected to the photovoltaic circuit 110 (the photovoltaic array 101). Further, the predetermined points O1 and O2 may be the same predetermined point O on the same connection line. In other words, the predetermined point O may be connectable to the first direct current power supply 23A and the second direct current power supply 23B through a c contact switch such that the predetermined point O is selectively connected to the first direct current power supply 23A or the second direct current power supply 23b. In this case, a circuit configuration can be simplified by reducing the number of switches, and malfunction of connecting both the first direct current power supply 23A and the second direct current power supply 23B to the photovoltaic circuit 110 can be prevented.

Further, in the embodiments described above, while the power conditioner 102 is included as the load device, the load device may be a device which consumes or converts power or may be a direct current load, such as a converter or a storage battery. Incidentally, "the same" described above includes substantially the same and allows a variation or an error on manufacture, design or measurement. In the above, the first direct current power supply 23A and the second direct current power supply 23B may be considered to constitute a direct current voltage generation unit, the voltage source 111 may be considered to constitute the first and second direct current power supplies, and the direct current power supply 23C may be considered to constitute the first and second direct current power supplies.

Here, in the present embodiment, it is desirable for the first electrical ground path to include the first resistor connected in series, the second electrical ground path to include the second resistor, the first measurement process to include causing the measurement unit to measure the measurement value for the current flowing in the first resistor as the first measurement value, and the second measurement process to include causing the measurement unit to measure the measurement value for the current flowing in the second resistor as the second measurement value. In this case, with intervention of the first and second resistors, it is possible to suppress damage of the photovoltaic circuit due to an overcurrent.

Further, it is desirable for the first predetermined point and the second predetermined point of the photovoltaic circuit to have the same potential at least when a rated output of the photovoltaic circuit is assumed. In this case, it is possible to detect the insulation resistance value and the potential of the ground fault point without considering the potentials of the first and second predetermined points.

Further, it is preferable for the first predetermined point and the second predetermined point of the photovoltaic circuit to be located on the same connection line. Since substantially the same potential is maintained on the same connection line irrespective of an output situation of the photovoltaic circuit, it is possible to accurately detect the insulation resistance value and the potential of the ground fault point irrespective of the output situation of the photovoltaic circuit by providing the first predetermined point and the second predetermined point on the same connection line.

Further, a second direct current power supply provided in series with the second resistor on the second electrical ground path and applying a second direct current voltage value to the photovoltaic circuit may be further included, and a second measurement process may include causing the second electrical ground path to be connected to a second predetermined point of the photovoltaic circuit insulated with respect to the ground, causing the second direct current power supply to apply the second direct current voltage value to the photovoltaic circuit, and causing the measurement unit to measure the second measurement value in this state. Accordingly, it is possible to apply two types of direct current voltages to the photovoltaic circuit, freely control the potential relative to the ground of the photovoltaic circuit, and reliably detect the ground fault.

Further, it is desirable for the absolute value of the difference of the first and second direct current voltage values to satisfy Equation (1) below when the first direct current voltage value is $V_1$, the second direct current voltage value is $V_2$, and the inter-electrode voltage value of the photovoltaic circuit is $V_s$.

$$1/2 \cdot |V_s| \leq |V_1 - V_2| \leq 3 \times |V_s| \quad \dots \quad (1)$$

Here, when the difference between the first and second direct current voltages is very small, there is concern of so-called precision loss (a phenomenon that the number of significant digits is reduced) in the calculation process when the ground fault is detected based on the first and second measurement values. On the other hand, when the difference between the first and second direct current voltages is very great, there is concern of a high potential relative to the ground (an overvoltage relative to the ground) being generated in the photovoltaic circuit, and a large current flowing in the case of short-circuit. In this regard, according to Equation (1) above, it is possible to suitably reduce both generation of the precision loss and generation of the high potential relative to the ground described above. As a result, it is possible to perform the ground fault detection with high sensitivity while increasing safety.

Further, it is desirable for the first measurement process to include causing the first direct current voltage value to be applied so that the potential of the negative electrode of the photovoltaic circuit is equal to or more than the ground potential, and for the second measurement process to include causing the second direct current voltage value to be applied so that the potential of the positive electrode of the photovoltaic circuit is equal to or less than the ground potential. In this case, since the current flowing in the ground fault point in the first measurement process and the current flowing in the ground fault point in the second measurement process always have different signs irrespective of the ground fault point, it is possible to further suppress the generation of the precision loss described above and to perform the ground fault detection with higher sensitivity.

Further, it is desirable for the photovoltaic power generation system to include the surge absorber for causing the overvoltage generated in the photovoltaic power generation system to go to the ground, the first measurement process to include causing the first direct current voltage value to be applied so that the potential of the positive electrode of the photovoltaic circuit is equal to or less than the positive electrode-side setting potential of the surge absorber, and the second measurement process to include causing the second direct current voltage value to be applied so that the potential of the negative electrode of the photovoltaic circuit is equal to or more than the positive electrode-side setting potential of the surge absorber. In this case, it is possible to suppress operation of the surge absorber when the first and second direct current voltage values are applied to the photovoltaic circuit and to prevent accurate first and second measurement values from not being measured due to the operation of the surge absorber.

**Industrial Applicability**

The present invention can be applied to a ground fault detection device, a ground fault detection method, a photovoltaic power generation system, and a ground fault detection program, and it is possible to detect the ground fault with high accuracy at a low cost.

**Reference Signs List**

1 ... Ground detection device, 2, 202, 302, 402 ... Measurement unit, 3 ... Calculation control unit (control unit or computer), 21A ... First electrical ground path, 21B ... Second electrical ground path, 22 ... Resistor (first resistor or second resistor), 22A ... First resistor, 22B ... Second resistor, 23A ... First direct current power supply (direct current voltage generation unit), 23B ... Second direct current power supply (direct current voltage generation unit), 23C ... Direct current power supply (first and second direct current power supplies or direct current voltage generation unit), 100 ... Photovoltaic power generation system, 102 ... Power conditioner (load device), 102b ... Surge absorber, 110 ... Photovoltaic circuit, 111 ... Voltage source (first direct current power supply, second direct current power supply, or direct current voltage generation unit), $I_1$ ... First current value (first measurement value), $I_2$ ... Second current value (second measurement value), G ... Ground, O ... Measurement point (first measurement point or second measurement point), $O_1$ ... First predetermined point, $O_2$ ... Second predetermined point, $V_1$ ... First direct current voltage value, $V_2$ ... Second direct current voltage value, $V_{d1}$ ... First voltage value (first measurement value), $V_{d2}$ ... Second voltage value (second measurement value).

**Claims**

1. A ground fault detection device for detecting a ground fault within a photovoltaic circuit in a photovoltaic power generation system including the photovoltaic circuit which performs power generation using solar light, and a load device which consumes or converts power generated by the photovoltaic circuit, the ground fault detection device comprising:

   a first electrical ground path having one side connected to a ground and the other side connectable to a first predetermined point of the photovoltaic circuit;
   a second electrical ground path having one side connected to the ground and the other side connectable to a second predetermined point of the photovoltaic circuit;
   a first direct current power supply provided on the first electrical ground path and applying a first direct current voltage value to the photovoltaic circuit;
   a measurement unit which measures a first measurement value for a current flowing in the first electrical ground path and a second measurement value for a current flowing in the second electrical ground path; and
   a control unit which performs control of operation of the measurement unit and ground fault detection based on the first and second measurement values measured by the measurement unit,
   wherein the control unit executes
   a first measurement process for causing the first electrical ground path to be connected to the photovoltaic circuit insulated with respect to the ground, causing the first direct current power supply to apply the first direct current voltage value to the photovoltaic circuit, and causing the measurement unit to measure the first measurement value in this state;
   a second measurement process for causing the second electrical ground path to be connected to the photovoltaic circuit insulated with respect to the ground, and causing the measurement unit to measure the second measurement value in this state; and
   a ground fault detection process for performing detection of the ground fault based on the first and second measured measurement values.

2. The ground fault detection device according to claim 1, wherein:

   the first electrical ground path includes a first resistor connected in series,
   the second electrical ground path includes a second resistor,
   the first measurement process includes causing the measurement unit to measure a measurement value for a current flowing in the first resistor as the first measurement value, and
   the second measurement process includes causing the measurement unit to measure a measurement value for a current flowing in the second resistor as the second measurement value.

3. The ground fault detection device according to claim 1 or 2, wherein the first predetermined point and the second predetermined point of the photovoltaic circuit have the same potential at least when a rated output of the photovoltaic circuit is assumed.

4. The ground fault detection device according to any one of claims 1 to 3, wherein the first predetermined point and the second predetermined point of the photovoltaic circuit are located on a same connection line.

5. The ground fault detection device according to claim 2, further comprising a second direct current power supply provided in series with the second resistor on the second electrical ground path and applying a second direct current voltage value to the photovoltaic circuit,
wherein the second measurement process includes causing the second electrical ground path to be connected to the second predetermined point of the photovoltaic circuit insulated with respect to the ground, causing the second direct current power supply to apply the second direct current voltage value to the photovoltaic circuit, and causing the measurement unit to measure the second measurement value in this state.

6. A ground fault detection device for detecting a ground fault within a photovoltaic circuit in a photovoltaic power generation system including the photovoltaic circuit which performs power generation using solar light, and a load device which consumes or converts power generated by the photovoltaic circuit, the ground fault detection device comprising:

a direct current voltage generation unit having one side connected to a ground and the other side connectable to a predetermined point of the photovoltaic circuit, and generating and outputting at least a first direct current voltage value and a second direct current voltage value;
a measurement unit which measures a first and second measurement values for a current flowing from the predetermined point to the ground; and
a control unit which performs control of operation of the measurement unit and the direct current voltage generation unit, and ground fault detection based on a measurement result of the measurement unit,
wherein the control unit executes
a first measurement process for causing the direct current voltage generation unit to be connected to the photovoltaic circuit insulated with respect to the ground, causing the direct current voltage generation unit to apply the first direct current voltage value to the predetermined point, and causing the measurement unit to measure the first measurement value in this state;
a second measurement process for causing the direct current voltage generation unit to be connected to the photovoltaic circuit insulated with respect to the ground, causing the direct current voltage generation unit to apply the second direct current voltage value to the predetermined point, and causing the measurement unit to measure the second measurement value in this state; and
a ground fault detection process for performing detection of the ground fault based on the first and second measured measurement values.

7. The ground fault detection device according to claim 5 or 6, wherein an absolute value of a difference of the first and second direct current voltage values satisfies Equation (1) below when the first direct current voltage value is $V_1$, the second direct current voltage value is $V_2$, and the inter-electrode voltage value of the photovoltaic circuit is $V_s$.

$$1/2 \cdot |V_s| \leq |V_1 - V_2| \leq 3 \times |V_s| \quad \ldots \quad (1)$$

8. The ground fault detection device according to claim 5 or 6, wherein:

the first measurement process includes causing the first direct current voltage value to be applied so that a potential of a negative electrode of the photovoltaic circuit is equal to or more than a ground potential, and
the second measurement process includes causing the second direct current voltage value to be applied so that a potential of a positive electrode of the photovoltaic circuit is equal to or less than the ground potential.

9. The ground fault detection device according to any one of claims 5 to 8, wherein:

the photovoltaic power generation system includes a surge absorber for causing an overvoltage generated in the photovoltaic power generation system to go to the ground,
the first measurement process includes causing the first direct current voltage value to be applied so that the potential of the positive electrode of the photovoltaic circuit is equal to or less than a positive electrode-side setting potential of the surge absorber, and
the second measurement process includes causing the second direct current voltage value to be applied so that the potential of the negative electrode of the photovoltaic circuit is equal to or more than the positive electrode-side setting potential of the surge absorber.

10. A ground fault detection method for detecting a ground fault within a photovoltaic circuit in a photovoltaic power generation system including the photovoltaic circuit which performs power generation using solar light, and a load device which consumes or converts power generated by the photovoltaic circuit, the ground fault detection method comprising:

a first measurement step for applying a first direct current voltage value between a first predetermined point of the photovoltaic circuit insulated with respect to a ground and the ground, and measuring a first measurement value for a current flowing between the first predetermined point and the ground in this state;
a second measurement step for applying a second direct current voltage value different from the first direct current voltage value between a second predetermined point of the photovoltaic circuit insulated with respect to the ground and the ground, and measuring a second measurement value for a current flowing between the second predetermined point and the ground in this state; and
a ground fault detection step for detecting the ground fault based on the first and second measured measurement values.

11. A photovoltaic power generation system comprising:

a photovoltaic circuit which performs power generation using solar light;
a load device which consumes or converts power generated by the photovoltaic circuit; and
the ground fault detection device according to any one of claims 1 to 9.

12. A ground fault detection program for detecting a ground fault within a photovoltaic circuit in a photovoltaic power generation system including the photovoltaic circuit which performs power generation using solar light, and a load device which consumes or converts power generated by the photovoltaic circuit, the ground fault detection program causing a computer to execute:

a first measurement function for applying a first direct current voltage value between a first predetermined point of the photovoltaic circuit insulated with respect to a ground and the ground, and measuring a first measurement value for a current flowing between the first predetermined point and the ground in this state; and
a second measurement function for applying a second direct current voltage value different from the first direct current voltage value between a second predetermined point of the photovoltaic circuit insulated with respect to the ground and the ground, and measuring a second measurement value for a current flowing between the second predetermined point and the ground in this state.

**Fig.1**

Fig.2

# Fig.3

EP 2 741 094 A1

# Fig.4

3

Measurement unit ←--→

- First connection control function
- First direct current voltage applying function
- First current measurement function
- Second connection control function
- Second direct current voltage applying function
- Second current measurement function
- Storage function
- Ground fault detection function

Storage unit

# Fig.5

START

Turn first switch unit on and second switch unit off — S1

Apply first direct current voltage value to photovoltaic array — S2

Measure and store first current value — S3

Turn first switch unit off and second switch unit on — S4

Apply second direct current voltage value to photovoltaic array — S5

Measure and store second current value — S6

Calculate insulation resistance value of ground fault point — S7

Calculate potential of ground fault point — S8

Determine ground fault — S9

END

## Fig.6

(a)

| When first direct current voltage value is applied | When second direct current voltage value is applied |

Photovoltaic circuit
positive electrode

●

Photovoltaic circuit
positive electrode

● ---------- ●------ Ground
potential

Photovoltaic circuit
negative electrode

●

Photovoltaic circuit
negative electrode

(b)

| When first direct current voltage value is applied | When second direct current voltage value is applied |

Photovoltaic circuit
positive electrode

●

Photovoltaic circuit
positive electrode

●

--------------------------- Ground
potential

●

Photovoltaic circuit
negative electrode

●

Photovoltaic circuit
negative electrode

EP 2 741 094 A1

# Fig.7

(a)

| When first direct current voltage value is applied | When second direct current voltage value is applied |
|---|---|

Photovoltaic circuit positive electrode

Photovoltaic circuit negative electrode

Ground potential

Photovoltaic circuit positive electrode

Photovoltaic circuit negative electrode

(b)

| In normal state | When first direct current voltage value is applied | When second direct current voltage value is applied |
|---|---|---|

Positive electrode-side setting potential of surge absorber

Photovoltaic circuit positive electrode

Photovoltaic circuit positive electrode

Ground potential

Photovoltaic circuit positive electrode

Photovoltaic circuit negative electrode

Photovoltaic circuit negative electrode

Photovoltaic circuit negative electrode

Negative electrode-side setting potential of surge absorber

EP 2 741 094 A1

# Fig.8

*Fig.9*

Fig.10

*Fig.11*

(a)

(b)

(c)

(d)

Fig.12

## INTERNATIONAL SEARCH REPORT

| International application No. |
| --- |
| PCT/JP2012/069462 |

**A. CLASSIFICATION OF SUBJECT MATTER**
*G01R31/02*(2006.01)i, *H01L31/04*(2006.01)i, *H01L31/042*(2006.01)i

According to International Patent Classification (IPC) or to both national classification and IPC

**B. FIELDS SEARCHED**

Minimum documentation searched (classification system followed by classification symbols)
G01R31/02, H01L31/04, H01L31/042

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 04-166773 A  (Kyocera Corp.), 12 June 1992 (12.06.1992), entire text; all drawings (Family: none) | 1-12 |
| Y | JP 54-104778 A  (Tokyo Shibaura Electric Co., Ltd.), 17 August 1979 (17.08.1979), fig. 3 (Family: none) | 1-12 |
| Y | JP 2010-199443 A  (Mitsubishi Heavy Industries, Ltd.), 09 September 2010 (09.09.2010), paragraph [0025]; fig. 1 (Family: none) | 7,9 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 30 August, 2012 (30.08.12) | 11 September, 2012 (11.09.12) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

| | INTERNATIONAL SEARCH REPORT | International application No. |
|---|---|---|
| | | PCT/JP2012/069462 |

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2000-197201 A  (Denso Corp.),<br>14 July 2000 (14.07.2000),<br>paragraphs [0017] to [0020]; fig. 1<br>(Family: none) | 1-12 |
| A | JP 11-218554 A  (Matsushita Electric Industrial Co., Ltd.),<br>10 August 1999 (10.08.1999),<br>paragraphs [0051] to [0065]; fig. 14<br>& US 6320389 B1          & EP 913697 A2<br>& DE 69842045 D          & TW 403838 B<br>& CN 1216826 A          & KR 10-0504690 B1 | 1-12 |
| A | WO 2010/150601 A1  (Nippon Oil Co., Ltd.),<br>29 December 2010 (29.12.2010),<br>paragraph [0020]; fig. 1<br>& EP 2447725 A1          & WO 2010/150601 A1 | 1-12 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003158282 A